# EUROPEAN PATENT SPECIFICATION

(11) **EP 3 620 550 B1**
(45) Date of publication and mention of the grant of the patent: **01.05.2024**
(21) Application number: 19194473.5
(22) Date of filing: 29.08.2019
(51) Int. Cl.: C23C 16/40, C23C 16/455, C23C 16/56, C23C 16/32

(54) **METHODS FOR MAKING SILICON CONTAINING FILMS THAT HAVE HIGH CARBON CONTENT**
VERFAHREN ZUR HERSTELLUNG VON SILICIUMHALTIGEN SCHICHTEN MIT HOHEM KOHLENSTOFFGEHALT
PROCÉDÉS DE FABRICATION DE FILMS CONTENANT DU SILICIUM ET À FORTE TENEUR EN CARBONE

(30) Priority: 29.08.2018 US 201862724109 P; 27.08.2019 US 201916553080
(43) Date of publication of application: 11.03.2020
(73) Proprietor: Versum Materials US, LLC, Tempe, AZ 85284 (US)
(72) Inventor: Lei, Xinjian, Tempe, Arizona 85284 (US); HARIPIN, Chandra, Tempe, Arizona 85284 (US); KIM, Moo-Sung, Tempe, Arizona 85284 (US)
(74) Representative: Beck Greener LLP

(56) References cited:
- US-A1- 2015 147 484
- US-A1- 2015 255 274
- US-A1- 2018 023 192
- US-A1- 2018 033 614

## Description

The present invention is directed to methods for the fabrication of an electronic device. More specifically, the invention is directed to methods for the deposition of a high oxygen ash resistant silicon-containing film such as, without limitation, a silicon carbide, a carbon doped silicon oxide film, and a carbon doped silicon oxynitride film.

### BACKGROUND OF THE INVENTION

US Pat. No. 8,575,033 describes methods for deposition of silicon carbide films on a substrate surface. The methods include the use of vapor phase carbosilane precursors and may employ plasma enhanced atomic layer deposition processes.

US Publ. No. 2013/022496 teaches a method of forming a dielectric film having Si-C bonds on a semiconductor substrate by atomic layer deposition (ALD) that includes the steps of: (i) adsorbing a precursor on a surface of a substrate; (ii) reacting the adsorbed precursor and a reactant gas on the surface; and (iii) repeating steps (i) and (ii) to form a dielectric film having at least Si-C bonds on the substrate.

PCT Publ. No. WO14134476A1 describes methods for the deposition of films comprising SiCN and SiOCN. Certain methods involve exposing a substrate surface to a first and second precursor, the first precursor having a formula (X_{y}H_{3-y}Si)zCH_{4-z}, (X_{y}H_{3-y}Si)(CH₂)(SiXₚH₂₋ₚ)(CH₂)(SiX_{y}H_{3-y}), or (X_{y}H_{3-y}Si)(CH₂)ₙ(SiX_{y}H_{3-y}), wherein X is a halogen, y has a value of between 1 and 3, and z has a value of between 1 and 3, p has a value of between 0 and 2, and n has a value between 2 and 5, and the second precursor comprising a reducing amine. Certain methods also include exposure of the substrate surface to an oxygen source to provide a film that includes carbon doped silicon oxide.

US Publ. No. 2014/287596A describes a method of manufacturing a semiconductor device including the steps of forming a thin film containing silicon, oxygen and carbon on a substrate by performing a cycle a predetermined number of times, the cycle including: supplying a precursor gas containing silicon, carbon and a halogen element and having an Si-C bonding, and a first catalytic gas to the substrate; and supplying an oxidizing gas and a second catalytic gas to the substrate.

US Pat. No. 9,343,290 B describes a method of manufacturing a semiconductor device that includes the steps of forming an oxide film on a substrate by performing a cycle a predetermined number of times. The cycle includes supplying a precursor gas to the substrate; and supplying an ozone gas to the substrate. In the act of supplying the precursor gas, the precursor gas is supplied to the substrate in a state by which a catalytic gas is not supplied to the substrate, and in the act of supplying the ozone gas, the ozone gas is supplied to the substrate in a state by which an amine-based catalytic gas is supplied to the substrate.

US Pat. No. 9,349,586 B discloses a thin film having a desirable etching resistance and a low dielectric constant.

US Publ. No. 2015/0044881 A describes a method of forming a film containing a high concentration of carbon with high controllability. A method of manufacturing a semiconductor device includes forming a film containing silicon, carbon and a predetermined element on a substrate by performing a cycle a predetermined number of times. The predetermined element is one of nitrogen and oxygen. The cycle includes supplying a precursor gas containing at least two silicon atoms per one mol., carbon and a halogen element to impart a Si-C bonding to the substrate, and supplying a modifying gas containing the predetermined element to the substrate.

US Pat. No 9,234, 276 discloses methods and systems for providing SiC films. A layer of SiC can be provided under process conditions that employ one or more Si-containing precursors that have ≥1 Si-H bonds and/or Si-Si bonds. The Si-containing precursors may also have ≥1 Si-O bonds and/or Si-C bonds. One or more radical species in a substantially low energy state can react with the Si-containing precursors to form the SiC film. The ≥1 radical species can be formed in a remote plasma source.

PCT Publ. No. WO12039833A describes methods for formation of silicon carbide on a substrate. Atomic layer deposition methods of forming silicon carbide are described in which a first reactant gas of the formula SiₙHₐX_{b}, wherein n=1-5, a+b=2n + 2, a>0, and X=F, Cl, Br, I, and a second reactant gas of the formula MR_{3-b}Y_{b}, wherein R is a hydrocarbon containing substituent, Y is a halide, hydride or other ligand and b=1-3, are sequentially deposited on a substrate and then exposed to a plasma. The process can be repeated multiple times to deposit a plurality of silicon carbide layers

US Pat. No 9,455,138 discloses a method for forming a dielectric film in a trench on a substrate by plasma-enhanced atomic layer deposition (PEALD) at ≥1 process cycles, each process cycle including (i) feeding a silicon-containing precursor in a pulse, (ii) supplying a hydrogen-containing reactant gas at a flow rate 30-800 sccm in the absence of nitrogen-containing gas, (iii) supplying a noble gas to the reaction space, and (iv) applying RF power in the presence of the reactant gas and the noble gas and in the absence of any precursor in the reaction space, to form a monolayer constituting a dielectric film on a substrate at a growth rate of less than one atomic layer thickness per cycle.

US Pat. No 8,722,546 discloses a method of forming a dielectric film having Si-C bonds and/or Si--N bonds on a semiconductor substrate by cyclic deposition, and includes the steps of: (i) conducting one or more cycles of cyclic deposition in a reaction space wherein a semiconductor substrate is placed, using a Si-containing precursor and a reactant gas; and (ii) before or after step (i), applying a pulse of RF power to the reaction space while supplying a rare gas and a treatment gas without supplying a Si-containing precursor, whereby a dielectric film having Si--C bonds and/or Si--N bonds is formed on the semiconductor substrate.

US2018/023192 describes compositions and methods for forming a silicon-containing film such as a carbon doped silicon oxide film, a carbon doped silicon nitride, a carbon doped silicon oxynitride film in a deposition process. The composition comprises at least cyclic carbosilane having at least one Si-C-Si linkage and at least one anchoring group selected from a halide atom, an amino group, and combinations thereof.

US2018/033614 discloses a composition and method for using the composition in the fabrication of an electronic device. Compounds, compositions and methods for depositing a low dielectric constant (<4.0) and high oxygen ash resistance silicon-containing film such as a carbon doped silicon oxide, are disclosed

The reference entitled "Highly Stable Ultrathin Carbosiloxane Films by Molecular Layer Deposition", Han, Z. et al., Journal of Physical Chemistry C, 117, 19967 (2013) teaches growing carbosiloxane film using 1,2-bis[(dimethylamino)dimethylsilyl]ethane and ozone. Thermal stability shows film is stable up to 40 °C with little thickness loss at 60 °C.

Liu et al, Jpn. J. Appl. Phys., 38, 3482-3486 (1999) teaches H₂ plasma use on polysilsesquioxane deposited with spin-on technology. The H₂ plasma provides stable dielectric constant and improves film thermal stability and O₂ ash (plasma) treatment.

Kim et al, Journal of the Korean Physical Society, 40, 94 (2002) teaches that H₂ plasma treatment on PECVD carbon doped silicon oxide film improves leakage current density (4-5 orders of magnitude) while dielectric constant increases from 2.2 to 2.5. The carbon doped silicon oxide film after H₂ plasma has less damage during an oxygen ashing process.

Posseme et al, Solid State Phenomena, 103-104, 337 (2005) teaches a H₂ / inert plasma treatment on carbon doped silicon oxide PECVD film. The k does not after a H₂ plasma treatment, which suggests no bulk modification.

The disclosure of the previously identified patents, patent applications and publications is hereby incorporated by reference.

There is a need in the art to provide a method using the same for depositing high carbon content-doped silicon-containing films for certain applications within the electronics industry. There is a further need for such films to have a carbon content of about 10 atomic % or greater as measured by X-ray photoelectron spectroscopy (XPS).

### BRIEF SUMMARY OF THE INVENTION

The above-described needs are met in one respect by providing a method for forming a carbon-doped silicon oxide film via a plasma ALD process according to claims 1 and 5 and further embodiments according to dependent claims . According to the method, a substrate that includes a surface feature is introduced into a reactor. The reactor is heated one or more temperatures ranging up to about 400°C. The reactor may be maintained at a pressure of 100 torr or less. At least one silicon precursor is introduced into the reactor having two Si-C-Si linkages selected from the group consisting of 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, and 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, 1,3-diiodo-1,3-dimethyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, and 1,5-diiodo-1,3,5-trisilapentane to form a chemisorbed layer on the substrate.

The reactor is purged of any unconsumed precursors and/or reaction by-products with a suitable inert gas. A plasma comprising hydrogen is introduced into the reactor to react with the chemisorbed layer having chemisorbed silicon, chloro/bromo/iodo, and carbon species. Exemplary plasma includes, but not limited to, hydrogen, hydrogen/argon, hydrogen/helium, hydrogen/neon or a combination thereof, which is generated either in situ or remotely.

Next, the reactor is again purged of any reaction by-products with a suitable inert gas. The steps of introducing the precursor(s), purging as necessary, introducing the plasma, and again purging as necessary, are repeated as necessary to bring the as-deposited silicon carbide film to a predetermined thickness.

The resulting silicon carbide film is then exposed to an oxygen source at one or more temperatures ranging from about ambient temperature to 1000°C, preferably from about 100° to 400°C, to introduce oxygen into film to result in a carbon doped silicon oxide film. Optionally, the carbon doped silicon oxide film is exposed to a plasma selected from the group consisting of hydrogen, inert gas and mixture of combination thereof. The carbon-doped silicon oxide film produced by these steps has a carbon content ranging between about 20 at. % and about 40 at. % based on XPS measurement and formed according to the inventive methods.

The disclosure describes a carbon-doped silicon oxide film having a dielectric constant k of 5 or less, preferably 4 or less, most preferable 3 or less, and a carbon content of at least about 20 at. %, preferably 30 at. % or greater, most preferably 35 at. % or greater based on XPS measurement and formed according to the inventive methods.

The disclosure also describes a silicon carbide film having a dielectric constant k of 9 or less, preferably 8 or less, most preferable 7 or less, and a carbon content of at least about 20 at. %, preferably 30 at. % or greater, most preferably 35 at. % or greater based on XPS measurement and formed according to the inventive methods.

Also described herein is amethod for depositing silicon carbide film onto at least a surface of a substrate. According to the method, the substrate is provided in a reactor, and the reactor is heated to one or more temperatures ranging from about 400°C to about 600°C. At least one precursor is introduced into the reactor selected from 1,1,1,3,3,3-hexachloro-1,3-disilapropane, 1,1,1,3,3,3-hexachloro-2-methyl-1,3-disilapropane, 1,1,3,3,3-hexachloro-2,2-dimethyl-1,3-disilapropane, 1,1,1,3,3,3-hexachloro-2-ethyl-1,3-disilapropane, 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, 1,3-diiodo-1,3-dimethyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, and 1,5-diiodo-1,3,5-trisilapentane. A plasma that includes a hydrogen source is then introduced into the reactor to react with at least a portion of the precursor to form the silicon carbide film.

The above-described needs and others can also be met by another method for forming a silicon carbide or carbon-doped silicon oxide film via a plasma enhanced ALD process. According to the method, a substrate that includes a surface feature is introduced into a reactor. The reactor is heated to one or more temperatures ranging up to about 600°C. The reactor may be maintained at a pressure of 100 torr or less. At least one silicon precursor is introduced into the reactor having one Si-C-Si linkage selected from the group consisting of 1,1,1,3,3,3-hexachloro-1,3-disilapropane, 1,1,1,3,3,3-hexachloro-2-methyl-1,3-disilapropane, 1,1,1,3,3,3-hexachloro-2,2-dimethyl-1,3-disilapropane, 1,1,1,3,3,3-hexachloro-2-ethyl-1,3-disilapropane to form a chemisorbed layer on the substrate.

The reactor is purged of any unconsumed precursors and/or reaction by-products with a suitable inert gas. A plasma that includes hydrogen is introduced into the reactor to react with the chemisorbed layer to form a silicon carbide film.

Next, the reactor is again purged of any reaction by-products with a suitable inert gas. The steps of introducing the precursor(s), purging as necessary, introducing the plasma, and again purging as necessary, are repeated as necessary to bring the silicon carbide film to a predetermined thickness.

The resulting silicon carbide film is then exposed to an oxygen source at one or more temperatures ranging from about ambient temperature to 1000°C, preferably from about 100° to 400°C, to convert the silicon carbide film into a carbon doped silicon oxide film. Then, the carbon doped silicon oxide film is exposed to a plasma that includes hydrogen. The carbon-doped silicon oxide film produced by these steps has a carbon content ranging between about 20 at. % and about 40 at. %.

### DETAILED DESCRIPTION OF THE INVENTION

Throughout the description, the term "ALD or ALD-like" refers to a process including, but not limited to, the following processes: a) each reactant including silicon precursor and reactive gas is introduced sequentially into a reactor such as a single wafer ALD reactor, semi-batch ALD reactor, or batch furnace ALD reactor; b) each reactant including silicon precursor and reactive gas is exposed to a substrate by moving or rotating the substrate to different sections of the reactor and each section is separated by inert gas curtain, i.e. spatial ALD reactor or roll to roll ALD reactor.

Throughout the description, the term "plasma comprising hydrogen" refers to a reactive gas or gas mixture generated in situ or remotely via a plasma generator. The gas or gas mixture is selected from the group consisting of hydrogen, a mixture of hydrogen and helium, a mixture of hydrogen and neon, a mixture of hydrogen and argon, and combination thereof.

Throughout the description, the term "inert gas plasma" refers to a reactive inert gas or inert gas mixture generated in situ or remotely via a plasma generator. The inert gas or inert gas mixture is selected from the group consisting of helium, neon, argon, and combination thereof.

Throughout the description, the term "ashing" refers to a process to remove the photoresist or carbon hard mask in semiconductor manufacturing process using a plasma comprising oxygen source such as O₂/inert gas plasma, O₂ plasma, CO₂ plasma, CO plasma, H₂/O₂ plasma or combination thereof.

Throughout the description, the term "damage resistance" refers to film properties after oxygen ashing process. Good or high damage resistance is defined as the following film properties after oxygen ashing: film dielectric constant lower than 4.5; carbon content in the bulk (at more than 50 Å deep into film) is within 5 at. % as compared with before ashing; less than 50 Å of the film is damaged, observed by differences in dilute HF etch rate between films near surface (less than 50 Å deep) and bulk (more than 50 Å deep).

Throughout the description, the term "alkyl hydrocarbon" refers a linear or branched C₁ to C₂₀ hydrocarbon, cyclic C₆ to C₂₀ hydrocarbon. Exemplary hydrocarbon includes, but not limited to, heptane, octane, nonane, decane, dodecane, cyclooctane, cyclononane, cyclodecane.

Throughout the description, the term "aromatic hydrocarbon" refers a C₆ to C₂₀ aromatic hydrocarbon. Exemplary aromatic hydrocarbon n includes, but not limited to, toluene, mesitylene.

Throughout the description, the term "catalyst" refers a Lewis base in vapor phase which can catalyze surface reaction between hydroxyl group and Si-CI bond during thermal ALD process. Exemplary catalysts include, but not limited to, at least one of a cyclic amine-based gas such as aminopyridine, picoline, lutidine, piperazine, piperidine, pyridine or an organic amine-based gas methylamine, dimethylamine, trimethylamine, ethylamine, diethylamine, triethylamine, propylamine, iso-propylamine, di-propylamine, di-iso-propylamine, tert-butylamine.

Throughout the description, the term "organic amines" refers a primary amine, secondary amine, tertiary amine having C₁ to C₂₀ hydrocarbon, cyclic C₆ to C₂₀ hydrocarbon. Exemplary organic amines include, but not limited to, methylamine, dimethylamine, trimethylamine, ethylamine, diethylamine, triethylamine, propylamine, iso-propylamine, di-propylamine, di-iso-propylamine, tert-butylamine.

Throughout the description, the term "siloxanes" refer a linear, branched, or cyclic liquid compound having at least one Si-O-Si linkages and C₄ to C₂₀ carbon atoms. Exemplary siloxanes includes, but not limited to, tetramethyldisiloxane, hexamethyldisiloxane (HMDSO), 1,1,1,3,3,5,5,5-octamethyltrisiloxane, octamethylcyclotetrasiloxane (OMCTS).

Throughout the description, the term "step coverage" as used herein is defined as a percentage of two thicknesses of the deposited film in a structured or featured substrate having either vias or trenches or both, with bottom step coverage being the ratio (in %): thickness at the bottom of the feature is divided by thickness at the top of the feature, and middle step coverage being the ratio (in %): thickness on a sidewall of the feature is divided by thickness at the top of the feature. Films deposited using the method described herein exhibit a step coverage of about 80% or greater, or about 90% or greater which indicates that the films are conformal.
Described herein are silicon precursor compositions, and methods comprising such compositions, to deposit a carbon doped (e.g., having a carbon content of about 20 at. % or greater as measured by XPS) silicon-containing film via a deposition process such as, without limitation, a plasma enhanced atomic layer deposition process. The film deposited using the composition and method described herein exhibits an extremely low etch rate such as an etch rate of at most 0.5 times that of thermal silicon oxide as measured in dilute hydrofluoric acid (e.g., about 0.20 Å/s or less or about 0.15 Å/s or less in dilute HF (0.5 wt. %), or an etch rate of at most 0.1 times that of thermal silicon oxide, or an etch rate of at most 0.05 times that of thermal silicon oxide, or an etch rate of at most 0.01 times that of thermal silicon oxide while exhibiting variability in other tunable properties such as, without limitation, density, dielectric constant, refractive index, and elemental composition.

The silicon precursors described herein, and methods using same, impart one or more of the following features in the following manner. First, the as-deposited, reactive carbon-doped silicon nitride film is formed using the silicon precursor precursors comprising at least one Si-C-Si linkage, and a nitrogen source. Without wishing to be bound by any theory or explanation, it is believed that the Si-C-Si linkage from the silicon precursor remains in the resulting as-deposited film and provides a high carbon content of at least 10 at. % or greater as measured by XPS (e.g., about 25 to about 50 at. %, about 30 to about 40 at. % and in some cases about 40 to about 50 at. % carbon). Second, when exposing the as-deposited film to an oxygen source, such as water, either intermittently during the deposition process, as a post-deposition treatment, or a combination thereof, at least a portion or all of the nitrogen content in the film is converted to oxygen to provide a film selected from a carbon-doped silicon oxide or a carbon-doped silicon oxynitride film. The nitrogen in the as-deposited film is released as one or more nitrogen-containing by-products such as ammonia or an amine group.

The final film is porous, perhaps due mainly to low density, and has a density of about 1.7 grams/cubic centimeter (g/cc) or less and an etch rate of 0.20 Å/s or less in 0.5 wt. % dilute hydrogen fluoride, an etch rate of 0.10 Å/s or less in 0.5 wt. % dilute hydrogen fluoride, an etch rate of 0.05 Å/s or less in 0.5 wt. % dilute hydrogen fluoride, an etch rate of 0.01 Å/s or less in 0.5 wt. % dilute hydrogen fluoride.

The composition for depositing a silicon-containing film comprises: (a) at least one silicon precursor compound having one Si-C-Si or two Si-C-Si linkages selected from the group consisting of 1,1,1,3,3,3-hexachloro-1,3-disilapropane, 1,1,1,3,3,3-hexachloro-2-methyl-1,3-disilapropane, 1,1,1,3,3,3-hexachloro-2,2-dimethyl-1,3-disilapropane, 1,1,1,3,3,3-hexachloro-2-ethyl-1,3-disilapropane, 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, and 1,3-diiodo-1,3-dimethyl-1,3-disilacyclobutane; and; (b) at least one solvent.

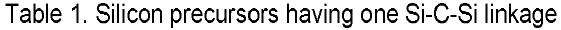

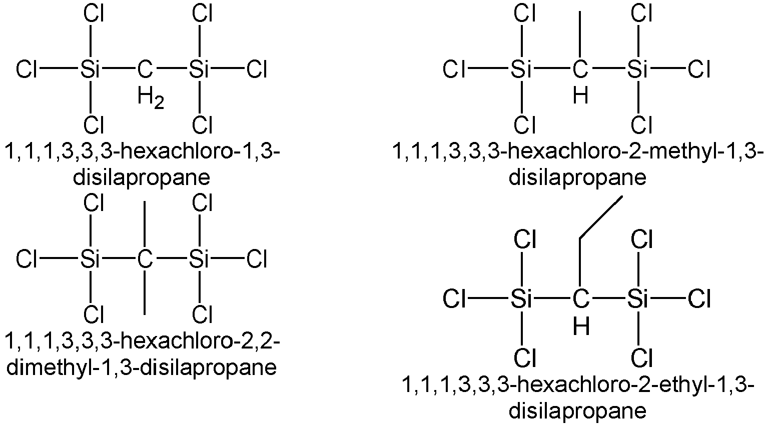

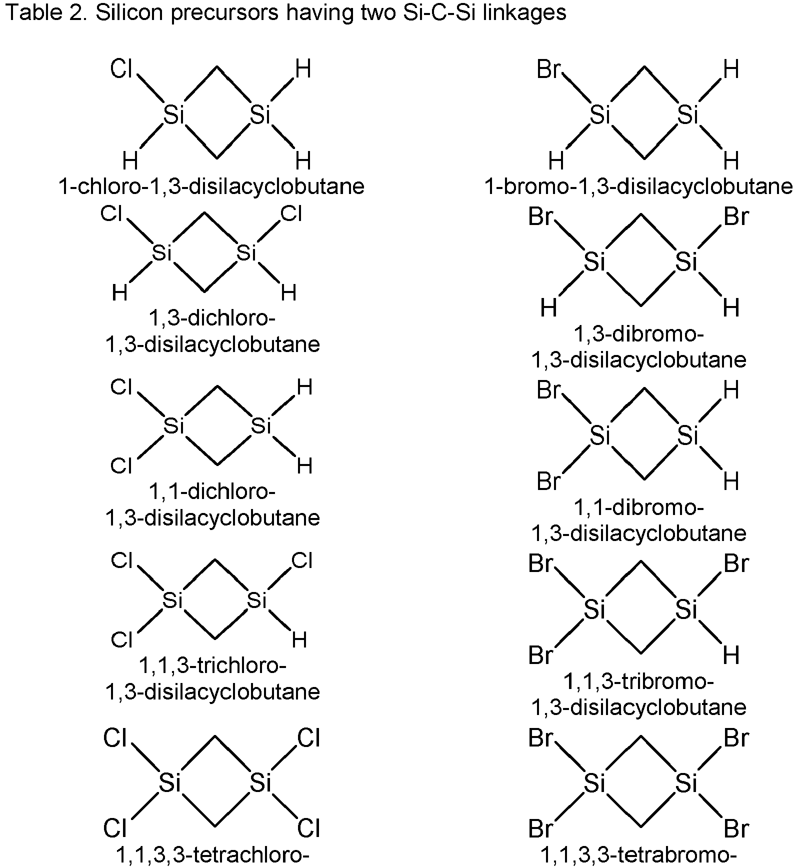

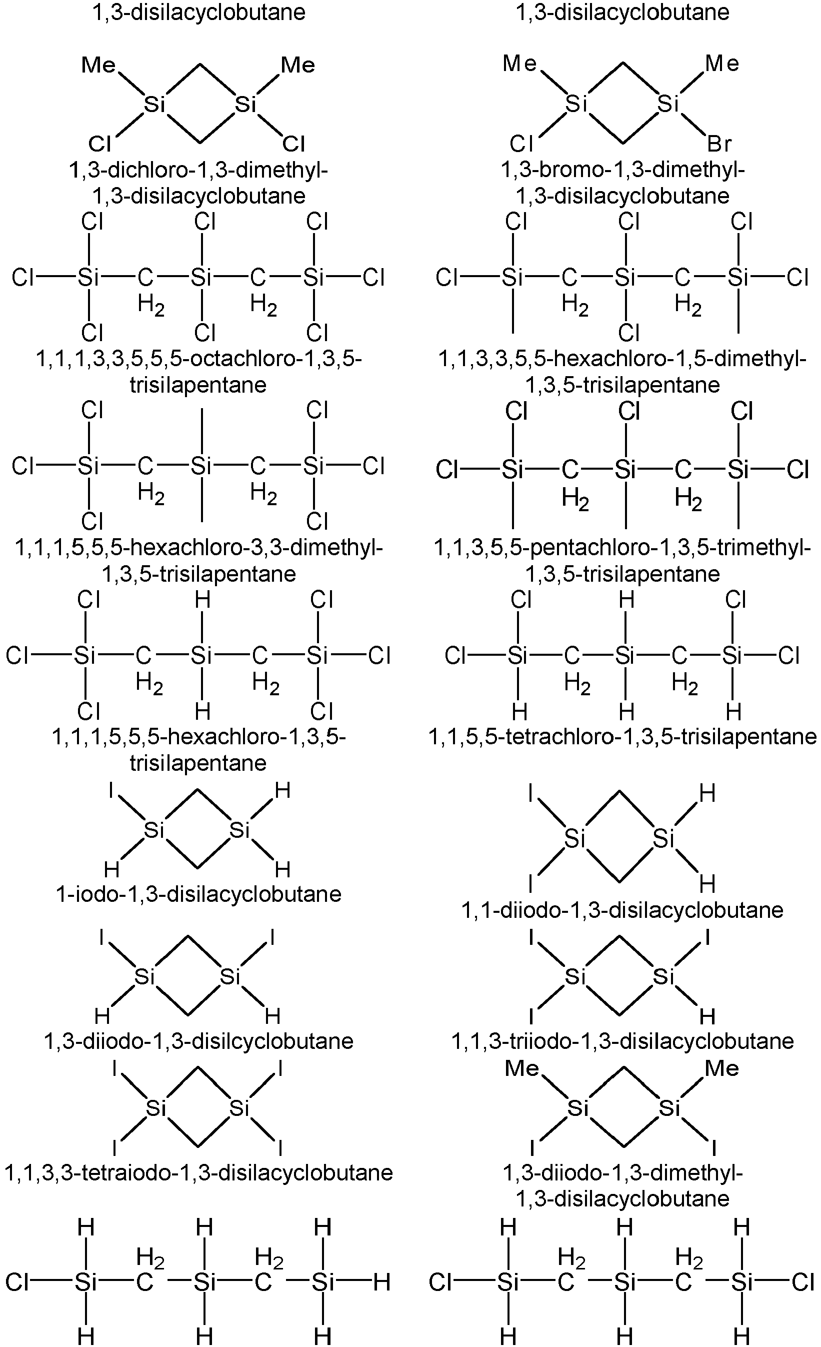

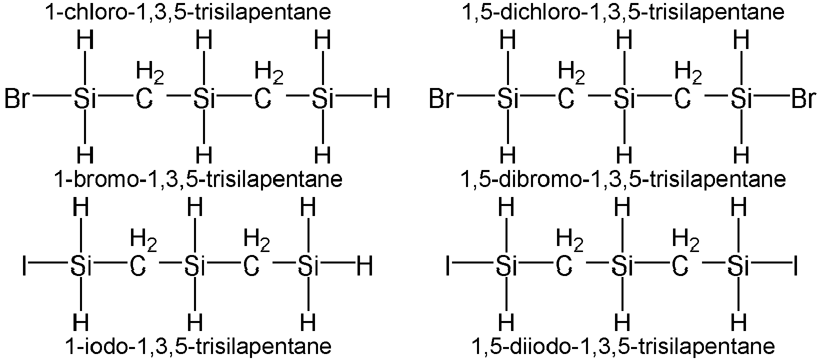

In the composition described herein, exemplary solvents can include, without limitation, ether, tertiary amine, alkyl hydrocarbon, aromatic hydrocarbon, tertiary aminoether, siloxanes, and combinations thereof. In certain embodiments, the difference between the boiling point of the compound having one SiC-Si or two Si-C-Si linkages and the boiling point of the solvent is 40°C or less. The wt % of silicon precursor compound in the solvent can vary from 1 to 99 wt %, or 10 to 90 wt%, or 20 to 80 wt %, or 30 to 70 wt %, or 40 to 60 wt %, to 50 to 50 wt %. In some embodiments, the composition can be delivered via direct liquid injection into a reactor chamber for silicon-containing film using conventional direct liquid injection equipment and methods.

In the method described herein, a silicon carbide or carbon doped silicon oxide film having carbon content ranging from 20 at. % to 40 at. % is deposited using a plasma enhanced ALD process. In this embodiment, the method comprises:
a. placing one or more substrates comprising a surface feature into a reactor
b. heating the reactor to one or more temperatures ranging from ambient temperature to about 600°C and optionally maintaining the reactor at a pressure of 100 torr or less;
c. introducing into the reactor at least one silicon precursor having one Si-C-Si linkage selected from the group consisting of 1,1,1,3,3,3-hexachloro-1,3-disilapropane, 1,1,1,3,3,3-hexachloro-2-methyl-1,3-disilapropane, 1,1,1,3,3,3-hexachloro-2,2-dimethyl-1,3-disilapropane, and 1,1,1,3,3,3-hexachloro-2-ethyl-1,3-disilapropane;
d. purge with an inert gas thereby removing unreacted silicon precursor and forming a composition comprising the purge gas and silicon precursor;
e. providing a plasma comprising hydrogen source into the reactor to react with the surface to form a silicon carbide film;
f. purge with inert gas to remove reaction by-products;
g. steps c to f are repeated to provide a desired thickness of the silicon carbide film;
h. optionally post-deposition treating the silicon carbide film with an oxygen source at one or more temperatures ranging from about ambient temperature to 1000°C or from about 100° to 400°C to convert the silicon carbide film into a carbon doped silicon oxide film either in situ or in another chamber; and
i. optionally post-deposition exposing the carbon doped silicon oxide film to a plasma comprising hydrogen to improve film properties to improve at least one of the films' properties;
j. optionally post-deposition treating the carbon doped silicon oxide film with thermal anneal or a spike anneal at temperatures from 400 to 1000C or a UV light source. In this or other embodiments, the UV exposure step can be carried out either during film deposition, or once deposition has been completed.

The substrate includes at least one feature wherein the feature comprises a pattern trench with aspect ratio of 1:9 or more, opening of 180 nm or less.

In the method described herein, a silicon carbide or carbon doped silicon oxide film having carbon content ranging from 20 at. % to 40 at. % is deposited using a plasma enhanced ALD process. In this embodiment, the method comprises:
a. placing one or more substrates comprising a surface feature into a reactor (e.g., into a conventional ALD reactor);
b. heating the reactor to one or more temperatures ranging from ambient temperature to about 400°C and optionally maintaining the reactor at a pressure of 100 torr or less;
c. introducing into the reactor at least one silicon precursor having two Si-C-Si linkages selected from the group consisting of 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, and 1,3-diiodo-1,3-dimethyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, and 1,5-diiodo-1,3,5-trisilapentane;
d. purge with an inert gas;
e. providing a plasma comprising hydrogen source into the reactor to react with the surface to form a silicon carbide film;
f. purge with inert gas to remove reaction by-products;
g. steps c to f are repeated to provide a desired thickness of the silicon carbide film;
h. optionally post-deposition treating the silicon carbide film with an oxygen source at one or more temperatures ranging from about ambient temperature to 1000°C or from about 100° to 400°C to convert the silicon carbide film into a carbon doped silicon oxide film either in situ or in another chamber;
i. optionally post-deposition exposing the carbon doped silicon oxide film to a plasma comprising hydrogen to improve at least one of the films' physical properties.
j. optionally post-deposition treating the carbon doped silicon oxide film with a thermal anneal at temperatures from 400 to 1000 °C or a UV light source. In this or other embodiments, the UV exposure step can be carried out either during film deposition, or once deposition has been completed.

A silicon precursor having 1:1 ratio of silicon to carbon is preferred for PEALD of silicon carbide. Suitable silicon precursors include, but not limited to, 1,1,1,3,3,3-hexachloro-2-methyl-1,3-disilapropane, 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, and 1,1,3,3-tetraiodo-1,3-disilacyclobutane. Not bound by theory, it is believed that such precursors might have better chance to provide stoichiometric silicon carbide.

The resulting carbon doped silicon oxide film is exposed to organoaminosilanes or chlorosilanes having Si-Me or Si-H or both to form a hydrophobic thin layer before exposing to hydrogen plasma treatment. Suitable organoaminosilanes include, but not limited to, diethylaminotrimethylsilane, dimethylaminotrimethylsilane, ethylmethylaminotrimethylsilane, t-butylaminotrimethylsilane, iso-propylaminotrimethylsilane, di-isopropylaminotrimethylsilane, pyrrolidinotrimethylsilane, diethylaminodimethylsilane, dimethylaminodimethylsilane, ethylmethylaminodimethylsilane, t-butylaminodimethylsilane, iso-propylaminodimethylsilane, di-isopropylaminodimethylsilane, pyrrolidinodimethylsilane, bis(diethylamino)dimethylsilane, bis(dimethylamino)dimethylsilane, bis(ethylmethylamino)dimethylsilane, bis(di-isopropyllamino)dimethylsilane, bis(iso-propylamino)dimethylsilane, bis(tert-butylamino)dimethylsilane, dipyrrolidinodimethylsilane, bis(diethylamino)diethylsilane, bis(diethylamino)methylvinylsilane, bis(dimethylamino)methylvinylsilane bis(ethylmethylamino)methylvinylsilane, bis(di-isopropyllamino)methylvinylsilane, bis(iso-propylamino)methylvinylsilane, bis(tert-butylamino)methylvinylsilane, dipyrrolidinomethylvinylsilane, 2,6-dimethylpiperidinomethylsilane, 2,6-dimethylpiperidinodimethylsilane, 2,6-dimethylpiperidinotrimethylsilane, tris(dimethylamino)phenylsilane, tris(dimethylamino)methylsilane, di-iso-propylaminosilane, di-sec-butylaminosilane, chlorodimethylsilane, chlorotrimethylsilane, dichloromethylsilane, and dichlorodimethylsilane.

The resulting carbon doped silicon oxide film is exposed to alkoxysilanes or cyclic alkoxysilanes having Si-Me or Si-H or both to form a hydrophobic thin layer before exposing to hydrogen plasma treatment. Suitable alkoxysilanes or cyclic alkoxysilanes include, but not limited to, diethoxymethylsilane, dimethoxymethylsilane, diethoxydmethylsilane, dimethoxydmethylsilane, 2,4,6,8-Tetramethylcyclotetrasiloxane, or octamethylcyclotetrasiloxane. Without wishing to be bound by any theory or explanation, it is believed that the thin layer formed by the organoaminosilanes or alkoxysilanes or cyclic alkoxysilanes may convert into dense carbon doped silicon oxide during plasma ashing process, further boosting the ashing resistance.

In the method described herein, a silicon carbide film having carbon content ranging from 30 at. % to 50 at. % is deposited using a plasma enhanced ALD process. In this embodiment, the method comprises:
a. placing one or more substrates comprising a surface feature into a reactor (e.g., into a conventional ALD reactor);
b. heating the reactor to one or more temperatures ranging from about 400C to about 600°C and optionally maintaining the reactor at a pressure of 100 torr or less;
c. introducing into the reactor at least one silicon precursor having two Si-C-Si linkages selected from the group consisting of 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, and 1,3-diiodo-1,3-dimethyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, 1,5-diiodo-1,3,5-trisilapentane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, and 1,5-diiodo-1,3,5-trisilapentane;
d. purge with an inert gas;
e. providing a plasma comprising hydrogen source into the reactor to react with the surface to form a silicon carbide film;
f. purge with inert gas to remove reaction by-products;
g. steps c to f are repeated to provide a desired thickness of the silicon carbide film;
h. optionally post-deposition treating the silicon carbide film at temperatures from 400 to 1000 °C or a UV light source or a plasma to further densify the as-deposited silicon carbide film. In this or other embodiments, the UV exposure step can be carried out either during film deposition, or once deposition has been completed.

In certain embodiments, the temperature of the reactor in the introducing step is at one or more temperatures ranging from about room temperature (e.g., 20°C) to about 600°C. Alternative ranges for the substrate temperature have one or more of the following end points: 20, 50, 75, 100, 125, 150, 175, 200, 225, 250, 275, 300, 325, 350, 375, 400, 425, 450, 475, and 500°C. Exemplary temperature ranges include the following: 20 to 300°C, 100 to 300°C or 100 to 350°C.

A vessel for depositing a silicon-containing film includes one or more silicon precursor compounds described herein. In one particular embodiment, the vessel is at least one pressurizable vessel (preferably of stainless steel having a design such as disclosed in U.S. Patent Nos. US7334595; US6077356; US5069244; and US5465766). The container can comprise either glass (borosilicate or quartz glass) or type 316, 316L, 304 or 304L stainless steel alloys (UNS designation S31600, S31603, S30400 S30403) fitted with the proper valves and fittings to allow the delivery of one or more precursors to the reactor for a CVD or an ALD process. In this or other embodiments, the silicon precursor is provided in a pressurizable vessel comprised of stainless steel and the purity of the precursor is 98% by weight or greater or 99.5% or greater which is suitable for the semiconductor applications. The silicon precursor compounds are preferably substantially free of metal ions such as, Al³⁺, Fe²⁺, Fe³⁺, Ni²⁺, Cr³⁺ ions. As used herein, the term "substantially free" as it relates to Al³⁺, Fe²⁺, Fe³⁺, Ni²⁺, Cr³⁺ means less than about 5 ppm (by weight), preferably less than about 3 ppm, and more preferably less than about 1 ppm, and most preferably about 0.1 ppm as measured by XPS. In certain embodiments, such vessels can also have means for mixing the precursors with one or more additional precursor if desired. In these or other embodiments, the contents of the vessel(s) can be premixed with an additional precursor. Alternatively, the silicon precursor is and/or other precursor can be maintained in separate vessels or in a single vessel having separation means for maintaining the silicon precursor is and other precursor separate during storage.

The silicon-containing film is deposited upon at least a surface of a substrate such as a semiconductor substrate. In the method described herein, the substrate may be comprised of and/or coated with a variety of materials well known in the art including films of silicon such as crystalline silicon or amorphous silicon, silicon oxide, silicon nitride, amorphous carbon, silicon oxycarbide, silicon oxynitride, silicon carbide, germanium, germanium doped silicon, boron doped silicon, metal such as copper, tungsten, aluminum, cobalt, nickel, tantalum), metal nitride such as titanium nitride, tantalum nitride, metal oxide, group III/V metals or metalloids such as GaAs, InP, GaP and GaN, and a combination thereof. These coatings may completely coat the semiconductor substrate, may be in multiple layers of various materials and may be partially etched to expose underlying layers of material. The surface may also have on it a photoresist material that has been exposed with a pattern and developed to partially coat the substrate. In certain embodiments, the semiconductor substrate comprising at least one surface feature selected from the group consisting of pores, vias, trenches, and combinations thereof. The potential application of the silicon-containing films include but not limited to low k spacer for FinFET or nanosheet, sacrificial hard mask for self-aligned patterning process (such as SADP, SAQP, or SAOP).

The deposition method used to form the silicon-containing films or coatings are deposition processes. Examples of suitable deposition processes for the method disclosed herein include, but are not limited to, a chemical vapor deposition or an atomic layer deposition process. As used herein, the term "chemical vapor deposition processes" refers to any process wherein a substrate is exposed to one or more volatile precursors, which react and/or decompose on the substrate surface to produce the desired deposition. As used herein, the term "atomic layer deposition process" refers to a self-limiting (e.g., the amount of film material deposited in each reaction cycle is constant), sequential surface chemistry that deposits films of materials onto substrates of varying compositions. Although the precursors, reagents and sources used herein may be sometimes described as "gaseous", it is understood that the precursors can be either liquid or solid which are transported with or without an inert gas into the reactor via direct vaporization, bubbling or sublimation. In some case, the vaporized precursors can pass through a plasma generator.

In one embodiment, the silicon-containing film is deposited using an ALD process. In another embodiment, not covered by the invention, silicon-containing film is deposited using a CCVD process. In a further embodiment, not covered by the inveention, the silicon-containing film is deposited using a thermal ALD process. The term "reactor" as used herein, includes without limitation, reaction chamber or deposition chamber.

In the method disclosed herein avoids pre-reaction of precursor(s) by using ALD or cyclic CVD methods that separate the precursor(s) prior to and/or during the introduction to the reactor. In this connection, deposition techniques such as ALD or CCVD processes are used to deposit the silicon-containing film. In one embodiment, the film is deposited via an ALD process in a typical single wafer ALD reactor, semi-batch ALD reactor, or batch furnace ALD reactor by exposing the substrate surface alternatively to the one or more the silicon-containing precursor, oxygen source, nitrogen-containing source, or other precursor or reagent. Film growth proceeds by self-limiting control of surface reaction, the pulse length of each precursor or reagent, and the deposition temperature. However, once the surface of the substrate is saturated, the film growth ceases. In another embodiment, each reactant including the silicon precursor and reactive gas is exposed to a substrate by moving or rotating the substrate to different sections of the reactor and each section is separated by inert gas curtain, i.e. spatial ALD reactor or roll to roll ALD reactor.

Depending upon the deposition method, in certain embodiments, the silicon precursors described herein and optionally other silicon-containing precursors may be introduced into the reactor at a predetermined molar volume, or from about 0.1 to about 1000 micromoles. In this or other embodiments, the precursor may be introduced into the reactor for a predetermined time period. In certain embodiments, the time period ranges from about 0.001 to about 500 seconds.

An oxygen source may be introduced into the reactor in the form of at least one oxygen source and/or may be present incidentally in the other precursors used in the deposition process. Suitable oxygen source gases may include, for example, air, water (H₂O) (e.g., deionized water, purified water, distilled water, water vapor, water vapor plasma, oxygenated water, air, a composition comprising water and other organic liquid), oxygen (O₂), oxygen plasma, ozone (O₃), nitric oxide (NO), nitrogen dioxide (NO₂), nitrous oxide (N₂O) carbon monoxide (CO), hydrogen peroxide (H₂O₂), a plasma comprising water, a plasma comprising water and argon, hydrogen peroxide, a composition comprising hydrogen, a composition comprising hydrogen and oxygen, carbon dioxide (CO₂), air, and combinations thereof. In certain embodiments, the oxygen source comprises an oxygen source gas that is introduced into the reactor at a flow rate ranging from about 1 to about 10000 standard cubic centimeters per minute (sccm) or from about 1 to about 1000 sccm. The oxygen source can be introduced for a time that ranges from about 0.1 to about 100 seconds.

When the film is deposited by an ALD or a cyclic CVD process, the precursor pulse can have a pulse duration that is greater than 0.01 seconds, and the oxygen source can have a pulse duration that is less than 0.01 seconds, while the water pulse duration can have a pulse duration that is less than 0.01 seconds.

The oxygen source is continuously flowing into the reactor while precursor pulse and plasma are introduced in sequence. The precursor pulse can have a pulse duration greater than 0.01 seconds while the plasma duration can range between 0.01 seconds to 100 seconds.

The deposition methods disclosed herein include one or more steps of purging unwanted or unreacted material from a reactor using purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon (Ne), hydrogen (H₂), and combinations thereof. In certain embodiments, a purge gas such as Ar is supplied into the reactor at a flow rate ranging from about 10 to about 10000 sccm for about 0.1 to 1000 seconds, thereby purging the unreacted material and any byproduct that may remain in the reactor.

The respective steps of supplying the precursors, the hydrogen-containing source, and/or other precursors, source gases, and/or reagents may be performed by changing the time for supplying them to change the stoichiometric composition of the resulting film.

Energy is applied to the at least one of the precursor, reducing agent such as hydrogen plasma, other precursors, or combinations thereof. Such energy can be provided by, but not limited to, thermal, plasma, pulsed plasma, helicon plasma, high density plasma, inductively coupled plasma, X-ray, e-beam, photon, remote plasma methods, and combinations thereof.

A secondary RF frequency source can be used to modify the plasma characteristics at the substrate surface. When the deposition involves plasma, the plasma-generated process may comprise a direct plasma-generated process in which plasma is directly generated in the reactor, or alternatively a remote plasma-generated process in which plasma is generated outside of the reactor and supplied into the reactor.

The silicon precursors and/or other silicon-containing precursors may be delivered to the reaction chamber, such as a CVD or ALD reactor, in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate.

It is understood that the steps of the methods described herein may be performed in a variety of orders, may be performed sequentially or concurrently (e.g., during at least a portion of another step), and any combination thereof. The respective step of supplying the precursors and the nitrogen-containing source gases may be performed by varying the duration of the time for supplying them to change the stoichiometric composition of the resulting silicon-containing film.

The film or the as-deposited film is subjected to a treatment step. The treatment step can be conducted during at least a portion of the deposition step, after the deposition step, and combinations thereof. Exemplary treatment steps include, without limitation, treatment via high temperature thermal annealing; plasma treatment; ultraviolet (UV) light treatment; laser; electron beam treatment and combinations thereof to affect one or more properties of the film. The films deposited with the silicon precursors having one or two Si-C-Si linkages described herein, when compared to films deposited with previously disclosed silicon precursors under the same conditions, have improved properties such as, without limitation, a wet etch rate that is lower than the wet etch rate of the film before the treatment step or a density that is higher than the density prior to the treatment step. In one particular embodiment, during the deposition process, as-deposited films are intermittently treated. These intermittent or mid-deposition treatments can be performed, for example, after each ALD cycle, after a certain number of ALD, such as, without limitation, one (1) ALD cycle, two (2) ALD cycles, five (5) ALD cycles, or after every ten (10) or more ALD cycles.

When the film is treated with a high temperature annealing step, the annealing temperature is at least 100°C or greater than the deposition temperature. In this or other embodiments, the annealing temperature ranges from about 400°C to about 1000°C. In this or other embodiments, the annealing treatment can be conducted in a vacuum (< 760 Torr), inert environment or in oxygen containing environment (such as H₂O, N₂O, NO₂ or O₂)

When the film is treated to UV treatment, film is exposed to broad band UV or, alternatively, an UV source having a wavelength ranging from about 150 nanometers (nm) to about 400 nm. In one particular embodiment, the as-deposited film is exposed to UV in a different chamber than the deposition chamber after a desired film thickness is reached.

When the film is treated with a plasma, passivation layer such as carbon doped silicon oxide is deposited to prevent chlorine and nitrogen contamination from penetrating film in the subsequent plasma treatment. The passivation layer can be deposited using atomic layer deposition or cyclic chemical vapor deposition.

When the film is treated with a plasma, the plasma source is selected from the group consisting of hydrogen plasma, plasma comprising hydrogen and helium, plasma comprising hydrogen and argon. Hydrogen plasma lowers film dielectric constant and boost the damage resistance to following plasma ashing process while still keeping the carbon content in the bulk almost unchanged.

The following examples illustrate certain aspects of the instant invention and do not limit the scope of the appended claims.

### EXAMPLES

In the following examples, unless stated otherwise, properties will be obtained from sample films that are deposited onto silicon wafer with resistivity of 5-20 Ω-cm as substrate. All film depositions are performed using the CN-1 reactor has showerhead design with 13.56 MHz direct plasma.

In typical process conditions, unless stated otherwise, the chamber pressure is fixed at a pressure ranging from about 1 to about 5 Torr. Additional inert gas is used to maintain chamber pressure.

The film depositions comprise the steps listed in Table 2 plasma enhanced ALD. Steps a through d in Table 2 constitute one ALD or PEALD cycle and are repeated, unless otherwise specified, a total of 100 or 200 or 300 or 500 times to get the desired film thickness.

**Table 2. Deposition Steps in PEALD of Carbon-doped Silicon Oxide or Silicon Carbide Films**

| Step | |
|---|---|
| a | Introduce vapors of a silicon precursor to the reactor; additional inert gas is used to maintain chamber pressure to provide a chemisorbed layer |
| b | Purge unreacted the silicon precursor from the reactor chamber with inert gas |
| c | Introduce a plasma source to react with the surface of the chemisorbed layer and create reactive sites |
| d | Purge reaction by-products out |

The refractive index (RI) and thickness for the deposited films are measured using an ellipsometer. Film non-uniformity is calculated using the standard equation: % non-uniformity = ((max thickness - min thickness)/(2*average (avg) thickness)). Film structure and composition are analyzed using Fourier Transform Infrared (FTIR) spectroscopy and X-Ray Photoelectron Spectroscopy (XPS). The density for the films is measured with X-ray Reflectometry (XRR). Wet etch rate was performed using about 0.5 wt.% hydrofluoric (HF) acid in deionized water. Thermal oxide wafers were used as reference for each batch to confirm solution concentration. Typical thermal oxide wafer wet etch rate for 0.5% HF in deionized water is 0.5 Å/s.

### Example 1.

### PEALD silicon carbide using 1,1,3,3-tetrachloro-1,3-disilacyclobutane and hydrogen plasma

The silicon wafer was loaded into the CN-1 reactor equipped with showerhead design with 13.56 MHz direct plasma and heated to 500°C with chamber pressure of 2 torr. 1,1,3,3-tetrachloro-1,3-disilacyclobutane was delivered as vapor into the reactor using bubbling or vapor draw.

The ALD cycle was comprised of the process steps provided in Table 2 and used the following process parameters:
a. Introduce vapors of 1,1,3,3-tetrachloro-1,3-disilacyclobutane to the reactor Argon flow: 100 sccm through precursor container
   pulse: 2 seconds
   Hydrogen flow: 500 sccm
b. Purge
   Hydrogen flow: 500 sccm
   Purge time: 5 seconds
c. Introduce hydrogen plasma
   Hydrogen flow 500 sccm
   Pulse: 5 seconds
   Plasma power: 100 W
d. Purge
   Hydrogen flow: 500 sccm
   Purge time: 5 seconds
Steps a to d were repeated for 500 cycles to provide a desired thickness of silicon carbide with a composition of 32.2 at.% carbon, 62.7 at. % silicon and 3.8 at.% oxygen. Refractive index (RI) is about 1.90. Having less than 5 at.% oxygen suggests the film is stable towards an oxygen source such as air. Thus it is possible to provide high quality silicon carbide.

### Example 2.

### PEALD silicon carbide using 1,1,3,3-tetrachloro-1,3-disilacyclobutane and hydrogen/argon plasma

The silicon wafer was loaded into the CN-1 reactor equipped with showerhead design with 13.56 MHz direct plasma and heated to 500°C with a chamber pressure of 2 torr. 1,1,3,3-tetrachloro-1,3-disilacyclobutane was delivered as vapor into the reactor using bubbling or vapor draw.

The ALD cycle was comprised of the process steps provided in Table 2 and used the following process parameters:
a. Introduce vapors of 1,1,3,3-tetrachloro-1,3-disilacyclobutane to the reactor
   Argon flow: 100 sccm through precursor container
   pulse: 2 seconds
   Argon flow: 100 sccm
   Hydrogen flow: 500 sccm
b. Purge
   Argon flow: 100 sccm
   Hydrogen flow: 500 sccm
   Purge time: 5 seconds
c. Introduce hydrogen plasma
   Argon flow 100 sccm
   Hydrogen flow: 500 sccm
   Pulse: 5 seconds
   Plasma power: 100 W
d. Purge
   Argon flow: 100 sccm
   Hydrogen flow: 500 sccm
   Purge time: 5 seconds
Steps a to d were repeated for 500 cycles to provide a desired thickness of silicon carbide with a composition of 37.9 at. % carbon, 52.4 at. % silicon, and 7.7 at. % oxygen. Refractive index (RI) is about 1.90. This experiment demonstrates that higher deposition temperatures could provide stable silicon carbide and the as-deposited film is less reactive towards an oxygen source such as air, thus providing less oxygen content following exposure to air.

### EXAMPLE 3

### PEALD carbon doped silicon oxide using 1,1,3,3-tetrachloro-1,3-disilacyclobutane and hydrogen/helium plasma

The silicon wafer was loaded into the CN-1 reactor equipped with a showerhead design with 13.56 MHz direct plasma and heated to 300°C with a chamber pressure of 2 torr. 1,1,3,3-tetrachloro-1,3-disilacyclobutane was delivered as vapor into the reactor using bubbling or vapor draw.

The ALD cycle was comprised of the process steps provided in Table 2 and used the following process parameters:
a) Introduce vapors of 1,1,3,3-tetrachloro-1,3-disilacyclobutane to the reactor
   Argon flow: 100 sccm
   Hydrogen flow: 250 sccm
   Helium flow: 250 sccm
   Pulse: 3 seconds
b) Purge
   Hydrogen flow: 250 sccm
   Helium flow: 250 sccm
   Purge time: 5 seconds
c) Introduce hydrogen plasma
   Hydrogen flow: 250 sccm
   Helium flow: 250 sccm
   Pulse: 5 seconds
   Plasma power: 300 W
d) Purge
   Hydrogen flow: 250 sccm
   Helium flow: 250 sccm
   Purge time: 5 seconds

Steps a to d were repeated for 300 cycles to provide thickness of silicon carbide. The resulting film was exposed to air and XPS measurement provided a composition of 36.2 at. % carbon, 36.3 at. % silicon and 20.3 at. % oxygen. Refractive index (RI) is about 1.90. These examples demonstrate that as-deposited silicon carbide is unstable as-deposited at a low deposition temperature (300⁰C ) and reactive to oxygen source such as air, allowing unexpectedly formation of carbon doped silicon oxide with carbon content higher than 30 at. %.

## Claims

1. A method for forming a carbon-doped silicon oxide film via a plasma enhanced ALD process, the method comprising:
a) providing a substrate comprising a surface feature in a reactor;
b) heating the reactor to one or more temperatures ranging from about 20°C to about 400°C and, optionally, maintaining the reactor at a pressure of 100 torr or less;
c) introducing into the reactor at least one silicon precursor having two Si-C-Si linkages selected from the group consisting of 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclobutane, 1,1,3,3-tetrachloro-1,3-disilacyclobutane, 1,1,3,3-tetrabromo-1,3-disilacyclobutane, 1,3-dichloro-1,3-dimethyl-1,3-disilacyclobutane, 1,3-bromo-1,3-dimethyl-1,3-disilacyclobutane, 1,1,1,3,3,5,5,5-octachloro-1,3,5-trisilapentane, 1,1,3,3,5,5-hexachloro-1,5-dimethyl-1,3,5-trisilapentane, 1,1,1,5,5,5-hexachloro-3,3-dimethyl-1,3,5-trisilapentane, 1,1,3,5,5-pentachloro-1,3,5-trimethyl-1,3,5-trisilapentane, 1,1,1,5,5,5-hexachloro-1,3,5-trisilapentane, and 1,1,5,5-tetrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tetraiodo-1,3-disilacyclobutane, 1,3-diiodo-1,3-dimethyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, and 1,5-diiodo-1,3,5-trisilapentane to anchor a chemisorbed layer on the substrate;
d) purging the reactor of any unconsumed precursors and/or reaction by-products from step c, with an inert gas;
e) providing a plasma comprising hydrogen into the reactor to react with the chemisorbed layer to form a silicon carbide film;
f) purging the reactor of any reaction by-products from step e with an inert gas;
g) repeating steps c to f as necessary to bring the silicon carbide film to a predetermined thickness;
h) exposing the resulting silicon carbide film to an oxygen source at one or more temperatures ranging from about ambient temperature to 1000°C to convert the silicon carbide film into a carbon doped silicon oxide film,
wherein the carbon-doped silicon oxide film has a carbon content ranging between about 20 at. % and about 40 at. %.

2. The method of Claim 1, further comprising performing a thermal anneal on the carbon doped silicon oxide film at temperatures from 300 to 1000°C.

3. The method of Claim 1 or 2, further comprising performing a plasma treatment on the carbon doped silicon oxide film with an inert gas plasma or hydrogen/inert plasma at a temperature ranging between 25°C and 600°C.

4. The method according to any one of claims 1 to 3, further comprising exposing the carbon doped silicon oxide film to an organoaminosilane, or a chlorosilane, having one or both of a Si-Me group and a Si-H group.

5. A method for forming a carbon-doped silicon oxide film via a plasma enhanced ALD process, the method comprising:
a) providing a substrate comprising a surface feature in a reactor;
b) heating the reactor to one or more temperatures ranging up to about 550°C and, optionally, maintaining the reactor at a pressure of 100 torr or less;
c) introducing into the reactor at least one silicon precursor having one Si-C-Si linkage selected from the group consisting of 1,1,1,3,3,3-hexachloro-1,3-disilapropane, 1,1,1,3,3,3-hexachloro-2-methyl-1,3-disilapropane, 1,1,1,3,3,3-hexachloro-2,2-dimethyl-1,3-disilapropane, and 1,1,1,3,3,3-hexachloro-2-ethyl-1,3-disilapropane to form a chemisorbed layer on the substrate;
d) purging the reactor of any unconsumed precursors and/or reaction by-products from step c, with an inert gas;
e) providing a plasma comprising hydrogen into the reactor to react with the chemisorbed layer to form a silicon carbide film;
f) purging the reactor of any reaction by-products from step e with an inert gas;
g) repeating steps c to f as necessary to bring the silicon carbide film to a predetermined thickness;
h) exposing the resulting silicon carbide film to an oxygen source at one or more temperatures ranging from about ambient temperature to 1000°C, preferably from about 100° to 400°C, to convert the silicon carbide film into a carbon doped silicon oxide film; and
wherein the carbon-doped silicon oxide film has a carbon content ranging between about 20 at. % and about 40 at. %.

6. The method according to claim 5, further comprising treating the carbon doped silicon oxide film with a spike anneal at temperatures from 400 to 1000°C.

7. The method according to claim 5 or 6, further comprising exposing the carbon doped silicon oxide film with a UV light source.

## Patentansprüche

1. Verfahren zum Bilden eines kohlenstoffdotierten Siliciumoxidfilms mithilfe eines plasmaunterstützten ALD-Prozesses, wobei das Verfahren umfasst:
a) Bereitstellen eines Substrats, das ein Oberflächenmerkmal umfasst, in einem Reaktor;
b) Erhitzen des Reaktors auf eine oder mehrere Temperaturen in einem Bereich von ungefähr 20 °C bis ungefähr 400 °C und wahlweise Führen des Reaktors bei einem Druck von 133,32 Pascal (100 Torr) oder weniger;
c) Einbringen zumindest eines Siliciumvorläufers mit zwei Si-C-Si-Verknüpfungen in den Reaktor, der aus der Gruppe ausgewählt ist, die aus 1-Chlor-1,3-disilacyclobutan, 1-Brom-1,3-disilacyclobutan, 1,3-Dichlor-1,3-disilacyclobutan, 1,3-Dibrom-1,3-disilacyclobutan, 1,1,3-Trichlor-1,3-disilacyclobutan, 1,1,3-Tribrom-1,3-disilacyclobutan, 1,1,3,3-Tetrachlor-1,3-disilacyclobutan, 1,1,3,3-Tetrabrom-1,3-disilacyclobutan, 1,3-Dichlor-1,3-dimethyl-1,3-disilacyclobutan, 1,3-Brom-1,3-Dimethyl-1,3-disilacyclobutan, 1,1,1,3,3,5,5,5-Octachlor-1,3,5-trisilapentan, 1,1,3,3,5,5-Hexachlor-1,5-dimethyl-1,3,5-trisilapentan, 1,1,1,5,5,5-Hexachlor-3,3-dimethyl-1,3,5-trisilapentan, 1,1,3,5,5-Pentachlor-1,3,5-trimethyl-1,3,5-trisilapentan, 1,1,1,5,5,5-Hexachlor-1,3,5-trisilapentan und 1,1,5,5-Tetrachlor-1,3,5-trisilapentan, 1-lod-1,3-disilacyclobutan, 1,1-Diiod-1,3-disilacyclobutan, 1,3-Diiod-1,3-disilacyclobutan, 1,1,3-Triiod-1,3-disilacyclobutan, 1,1,3,3-Tetraiod-1,3-disilacyclobutan, 1,3-Diiod-1,3-dimethyl-1,3-disilacyclobutan, 1-Chlor-1,3,5-trisilapentan, 1,5-Dichlor-1,3,5-trisilapentan, 1-Brom-1,3,5-trisilapentan, 1,5-Dibrom-1,3,5-trisilapentan, 1-lod-1,3,5-trisilapentan und 1,5-Diiod-1,3,5-trisilapentan besteht, um eine chemisorbierte Schicht auf dem Substrat zu verankern;
d) Spülen des Reaktors mit einem Inertgas, um sämtliche nicht verbrauchte Vorläufer und/oder Reaktionsnebenprodukte aus Schritt c) wegzuspülen;
e) Bereitstellen eines Plasmas, das Wasserstoff umfasst, in den Reaktor, um mit der chemisorbierten Schicht zu reagieren, so dass ein Siliciumcarbidfilm gebildet wird;
f) Spülen des Reaktors mit einem Inertgas, um sämtliche Reaktionsnebenprodukte aus Schritt e) wegzuspülen;
g) Wiederholen der Schritte c) bis f) nach Bedarf, um eine vorbestimmte Dicke des Siliciumcarbidfilms zu erzielen;
h) Aussetzen des entstehenden Siliciumcarbidfilms gegenüber einer Sauerstoffquelle bei einer oder mehreren Temperaturen im Bereich von ungefähr Umgebungstemperatur bis 1000 °C, um den Siliciumcarbidfilm in einen kohlenstoffdotierten Siliciumoxidfilm umzuwandeln,
wobei der kohlenstoffdotierte Siliciumoxidfilm einen Kohlenstoffgehalt im Bereich zwischen ungefähr 20 Atom-% und ungefähr 40 Atom-% aufweist.

2. Verfahren nach Anspruch 1, das ferner das Durchführen einer thermischen Ausheilung an dem kohlenstoffdotierten Siliciumoxidfilm bei Temperaturen von 300 bis 1000 °C umfasst.

3. Verfahren nach Anspruch 1 oder 2, das ferner das Durchführen einer Plasmabehandlung an dem kohlenstoffdotierten Siliciumoxidfilm mit einem Inertgasplasma oder Wasserstoff/Inertplasma bei einer Temperatur im Bereich zwischen 25 °C und 600 °C umfasst.

4. Verfahren nach einem der Ansprüche 1 bis 3, das ferner das Aussetzen des kohlenstoffdotierten Siliciumoxidfilms gegenüber einem Organoaminosilan oder einem Chlorsilan umfasst, das eine Si-Me-Gruppe und/oder eine Si-H-Gruppe aufweist.

5. Verfahren zum Bilden eines kohlenstoffdotierten Oxidfilms mithilfe eines plasmaunterstützten ALD-Prozesses, wobei das Verfahren umfasst:
a) Bereitstellen eines Substrats, das ein Oberflächenmerkmal umfasst, in einem Reaktor;
b) Erhitzen des Reaktors auf eine oder mehrere Temperaturen in einem Bereich von bis zu ungefähr 550 °C und wahlweise Führen des Reaktors bei einem Druck von 133,32 Pascal (100 Torr) oder weniger;
c) Einbringen zumindest eines Siliciumvorläufers mit einer Si-C-Si-Verknüpfung in den Reaktor, der aus der Gruppe ausgewählt ist, die aus 1,1,1,3,3,3-Hexachlor-1,3-disilapropan, 1,1,1,3,3,3-Hexachlor-2-methyl-1,3,-disilapropan, 1,1,1,3,3,3-Hexachlor-2,2-dimethyl-1,3-disilapropan und 1,1,1,3,3,3-Hexachlor-2-ethyl-1,3-disilapropan besteht, um eine chemisorbierte Schicht auf dem Substrat zu verankern;
d) Spülen des Reaktors mit einem Inertgas, um sämtliche nicht verbrauchte Vorläufer und/oder Reaktionsnebenprodukte aus Schritt c) wegzuspülen;
e) Bereitstellen eines Plasmas, das Wasserstoff umfasst, in den Reaktor, um mit der chemisorbierten Schicht zu reagieren, so dass ein Siliciumcarbidfilm gebildet wird;
f) Spülen des Reaktors mit einem Inertgas, um sämtliche Reaktionsnebenprodukte aus Schritt e) wegzuspülen;
g) Wiederholen der Schritte c) bis f) nach Bedarf, um eine vorbestimmte Dicke des Siliciumcarbidfilms zu erzielen;
h) Aussetzen des entstehenden Siliciumcarbidfilms gegenüber einer Sauerstoffquelle bei einer oder mehreren Temperaturen im Bereich von ungefähr Umgebungstemperatur bis 1000 °C, vorzugsweise ungefähr 100 °C bis 400 °C, um den Siliciumcarbidfilm in einen kohlenstoffdotierten Siliciumoxidfilm umzuwandeln; und
wobei der kohlenstoffdotierte Siliciumoxidfilm einen Kohlenstoffgehalt im Bereich zwischen ungefähr 20 Atom-% und ungefähr 40 Atom-% aufweist.

6. Verfahren nach Anspruch 5, das ferner das Behandeln des kohlenstoffdotierten Siliciumoxidfilms mithilfe einer Spike-Ausheilung bei Temperaturen von 400 bis 1000 °C umfasst.

7. Verfahren nach Anspruch 5 oder 6, das ferner das Aussetzen des kohlenstoffdotierten Siliciumoxidfilms gegenüber einer UV-Lichtquelle umfasst.

## Revendications

1. Procédé pour former un film d'oxyde de silicium dopé au carbone par le biais d'un processus ALD amélioré par plasma, le procédé comprenant :
a) la fourniture d'un substrat comprenant une caractéristique de surface dans un réacteur ;
b) le chauffage du réacteur à une ou plusieurs températures allant d'environ 20°C à environ 400°C et, facultativement, le maintien du réacteur à une pression inférieure ou égale à 100 torrs ;
c) l'introduction dans le réacteur d'au moins un précurseur de silicium ayant deux liaisons Si-C-Si choisi dans le groupe consistant en 1-chloro-1,3-disilacyclobutane, 1-bromo-1,3-disilacyclobutane, 1,3-dichloro-1,3-disilacyclobutane, 1,3-dibromo-1,3-disilacyclobutane, 1,1,3-trichloro-1,3-disilacyclobutane, 1,1,3-tribromo-1,3-disilacyclo-butane, 1,1,3,3-tétrachloro-1,3-disilacyclobutane, 1,1,3,3-tétrabromo-1,3-disilacyclo-butane, 1,3-dichloro-1,3-diméthyl-1,3-disilacyclobutane, 1,3-bromo-1,3-diméthyl-1,3-disilacyclobutane, 1,1,1,3,3,5,5,5-octachloro-1,3,5-trisilapentane, 1,1,3,3,5,5-hexachloro-1,5-diméthyl-1,3,5-trisilapentane, 1,1,1,5,5,5-hexachloro-3,3-diméthyl-1,3,5-trisilapentane, 1,1,3,5,5-pentachloro-1,3,5-triméthyl-1,3,5-trisilapentane, 1,1,1,5,5,5-hexachloro-1,3,5-trisilapentane, et 1,1,5,5-tétrachloro-1,3,5-trisilapentane, 1-iodo-1,3-disilacyclobutane, 1,1-diiodo-1,3-disilacyclobutane, 1,3-diiodo-1,3-disilacyclobutane, 1,1,3-triiodo-1,3-disilacyclobutane, 1,1,3,3-tétraiodo-1,3-disilacyclobutane, 1,3-diiodo-1,3-diméthyl-1,3-disilacyclobutane, 1-chloro-1,3,5-trisilapentane, 1,5-dichloro-1,3,5-trisilapentane, 1-bromo-1,3,5-trisilapentane, 1,5-dibromo-1,3,5-trisilapentane, 1-iodo-1,3,5-trisilapentane, et 1,5-diiodo-1,3,5-trisilapentane pour ancrer une couche chimisorbée sur le substrat ;
d) la purge du réacteur de tout précurseur et/ou sous-produit de réaction non consommés issus de l'étape c, avec un gaz inerte ;
e) la fourniture d'un plasma comprenant de l'hydrogène dans le réacteur pour réagir avec la couche chimisorbée pour former un film de carbure de silicium ;
f) la purge du réacteur de tout sous-produit de réaction issu de l'étape e, avec un gaz inerte ;
g) la répétition des étapes c à f autant que nécessaire pour amener le film de carbure de silicium à une épaisseur prédéterminée ;
h) l'exposition du film de carbure de silicium résultant à une source d'oxygène à une ou plusieurs températures allant d'environ la température ambiante à 1 000°C pour convertir le film de carbure de silicium en un film d'oxyde de silicium dopé au carbone,
dans lequel le film d'oxyde de silicium dopé au carbone a une teneur en carbone comprise entre environ 20 % at. et environ 40 % at.

2. Procédé selon la revendication 1, comprenant en outre la réalisation d'un recuit thermique sur le film d'oxyde de silicium dopé au carbone à des températures de 300°C à 1 000°C.

3. Procédé selon la revendication 1 ou 2, comprenant en outre la réalisation d'un traitement au plasma sur le film d'oxyde de silicium dopé au carbone avec un plasma de gaz inerte ou un plasma d'hydrogène/inerte à une température comprise entre 25°C et 600°C.

4. Procédé selon l'une quelconque des revendications 1 à 3, comprenant en outre l'exposition du film d'oxyde de silicium dopé au carbone à un organoaminosilane, ou un chlorosilane, ayant l'un ou les deux d'un groupe Si-Me et d'un groupe Si-H.

5. Procédé pour former un film d'oxyde de silicium dopé au carbone par le biais d'un processus ALD amélioré par plasma, le procédé comprenant :
a) la fourniture d'un substrat comprenant une caractéristique de surface dans un réacteur ;
b) le chauffage du réacteur à une ou plusieurs températures allant jusqu'à environ 550°C et, facultativement, le maintien du réacteur à une pression inférieure ou égale à 100 torrs ;
c) l'introduction dans le réacteur d'au moins un précurseur de silicium ayant une liaison Si-C-Si choisi dans le groupe consistant en 1,1,1,3,3,3-hexachloro-1,3-disilapropane, 1,1,1,3,3,3-hexachloro-2-méthyl-1,3-disilapropane, 1,1,1,3,3,3-hexachloro-2,2-diméthyl-1,3-disilapropane, et 1,1,1,3,3,3-hexachloro-2-éthyl-1,3-disilapropane pour ancrer une couche chimisorbée sur le substrat ;
d) la purge du réacteur de tout précurseur et/ou sous-produit de réaction non consommés issus de l'étape c, avec un gaz inerte ;
e) la fourniture d'un plasma comprenant de l'hydrogène dans le réacteur pour réagir avec la couche chimisorbée pour former un film de carbure de silicium ;
f) la purge du réacteur de tout sous-produit de réaction issu de l'étape e, avec un gaz inerte ;
g) la répétition des étapes c à f autant que nécessaire pour amener le film de carbure de silicium à une épaisseur prédéterminée ;
h) l'exposition du film de carbure de silicium résultant à une source d'oxygène à une ou plusieurs températures allant d'environ la température ambiante à 1 000°C, de préférence d'environ 100°C à 400°C, pour convertir le film de carbure de silicium en un film d'oxyde de silicium dopé au carbone ; et
dans lequel le film d'oxyde de silicium dopé au carbone a une teneur en carbone comprise entre environ 20 % at. et environ 40 % at.

6. Procédé selon la revendication 5, comprenant en outre le traitement du film d'oxyde de silicium dopé au carbone avec un recuit à pic de température à des températures de 400°C à 1 000°C.

7. Procédé selon la revendication 5 ou 6, comprenant en outre l'exposition du film d'oxyde de silicium dopé au carbone avec une source de lumière UV.
